# FASCICULE DE BREVET EUROPEEN

(11) **EP 4 088 309 B1**
(45) Date de publication et mention de la délivrance du brevet: **01.11.2023**
(21) Numéro de dépôt: 20845202.9
(22) Date de dépôt: 15.12.2020
(51) Int. Cl.: H01L 21/18, H01L 21/02, H01L 21/762

(54) **PROCEDE D'ASSEMBLAGE DE DEUX SUBSTRATS SEMI-CONDUCTEURS**
VERFAHREN ZUM VERBINDEN ZWEIER HALBLEITERSUBSTRATE
METHOD OF JOINING TWO SEMI-CONDUCTOR SUBSTRATES

(30) Priorité: 09.01.2020 FR 2000140
(43) Date de publication de la demande: 16.11.2022
(73) Titulaire: SOITEC, 38190 Bernin (FR)
(72) Inventeur: GAUDIN, Gweltaz, CROLLES 38920 (FR); FUTIN, Céline, 38400 SAINT MARTIN D'HERES (FR)
(74) Mandataire: IP Trust
(86) Numéro de dépôt international: PCT/FR2020/052439
(87) Numéro de publication internationale: WO 2021/140285

(56) Documents cités:
- CN-A- 110 098 140
- US-A- 4 818 323
- US-A- 4 939 101
- US-A- 6 010 591

## Description

### DOMAINE DE L'INVENTION

La présente invention concerne le domaine des matériaux semi-conducteurs pour composants microélectroniques. Elle concerne en particulier un procédé d'assemblage de deux substrats semi-conducteurs par adhésion moléculaire.

### ARRIERE PLAN TECHNOLOGIQUE DE L'INVENTION

L'assemblage de substrats par adhésion moléculaire (« Direct wafer bonding » selon la terminologie anglo-saxonne) est une technique bien connue qui trouve des applications dans les domaines de la microélectronique, l'optoélectronique, des microsystèmes électromécaniques, par exemple pour la fabrication de substrats de silicium sur isolant, de cellules photovoltaïques à jonctions multiples, l'élaboration de structures 3D.

Selon cette technique, deux substrats sont mis en contact intime de manière à rapprocher leur surface suffisamment proche l'une de l'autre pour qu'elles établissent entre elles des liaisons atomiques et/ou moléculaires. On crée ainsi des forces d'adhésion entre les deux surfaces de contact, sans employer de couche intermédiaire d'adhésion telle qu'une couche de colle ou polymère.

L'assemblage obtenu est ensuite généralement soumis à un traitement thermique à une température pouvant varier entre 50° et 1200°C, suivant la nature des substrats et l'application envisagée, de manière à renforcer l'adhésion.

L'assemblage par adhésion moléculaire entraîne dans certains cas l'apparition de défauts, appelés défauts de collage, au niveau de l'interface de collage. Il peut s'agir de défaut de type « bulle » (« bonding voids » selon la terminologie anglo-saxonne). Les défauts de collage peuvent résulter du piégeage et de l'accumulation d'espèces gazeuses entre les surfaces des substrats assemblés. Ces espèces peuvent correspondre aux espèces adsorbées en surface des substrats lors de leur préparation avant l'assemblage. Ils peuvent notamment correspondre à des résidus de réactions chimiques, notamment de la réaction chimique de l'eau, qui se produisent lors de la mise en contact intime des substrats ou lors du recuit de renforcement du collage.

La présence de défauts de collage à l'interface d'assemblage est fortement dommageable pour la qualité des structures produites. Par exemple, lorsque l'étape d'assemblage est suivie d'une étape d'amincissement d'un des deux substrats pour former une couche, par meulage ou selon la technique Smart Cut^{™}, l'absence d'adhésion entre les deux surfaces au niveau d'un défaut de collage peut conduire à l'arrachement local de la couche mince à cet endroit.

Par ailleurs, lorsqu'une structure composite, comprenant par exemple une couche mince en carbure de silicium (SiC) monocristallin assemblée sur un substrat support en SiC, est destinée à l'élaboration de dispositifs de puissance verticaux, une bonne conduction thermique et électrique entre la couche mince et le substrat support est requise.

Pour l'assemblage des substrats qui donneront lieu à la structure composite, il existe deux approches principales pour réaliser un collage direct : l'approche hydrophile et l'approche hydrophobe.

Dans l'approche hydrophile, les surfaces des deux substrats sont traitées pour les rendre hydrophiles en générant notamment une couche d'oxyde natif. Une couche d'eau est présente entre les deux substrats pour favoriser la création de liaisons atomiques et/ou moléculaires responsables des forces d'adhésion entre les deux substrats. Néanmoins, la présence de la couche d'oxyde natif à l'interface de collage impacte et détériore la conduction électrique entre les deux substrats.

Dans l'approche hydrophobe, les surfaces des deux substrats sont traitées pour être hydrophobes : la couche d'oxyde natif est retirée et on limite la présence d'eau entre les substrats. Pour limiter encore la présence d'eau, l'assemblage entre les deux substrats peut être réalisé dans une atmosphère contrôlée, tel qu'anhydre ou sous-vide. Deux substrats assemblés entre eux par cette approche présenteront une bonne conduction électrique et thermique verticale (Yushin et al, Applied Physics Letters, 84 (20), 3993-3995, 2004). Néanmoins, ces conditions peuvent être complexes à obtenir dans un milieu industriel. De plus, la demanderesse a constaté que lorsque les deux substrats de SiC assemblés par cette approche étaient soumis à une température supérieure à 700°C des bulles pressurisées pouvaient se former à l'interface entre les deux substrats et détériorer la qualité du collage. Cela est tout particulièrement gênant lorsque l'ensemble formé par l'assemblage des deux substrats doit être soumis à un traitement thermique à une température au-delà de laquelle apparaissent de telles bulles, par exemple pour effectuer un transfert de couche par le procédé Smart Cut^{™}.

Il existe également une autre approche basée sur le collage de surfaces actives (« surface active bonding » ou SAB selon la terminaison anglo-saxonne) comme par exemple décrit par F.Mu et al (4th IEEE International Workshop on Low Température Bonding for 3D Intégration (LTB-3D), 15-16 July 2014). Les surfaces des deux substrats à assembler sont soumises à un bombardement d'atomes pour activer leur surface avant de les assembler entre elles à basse température. Cette approche permet d'obtenir une très bonne force d'adhésion entre les deux substrats mais forme une couche amorphe à l'interface entre les deux substrats. La présence de cette couche amorphe détériore généralement la conductivité entre les deux substrats.

Autre état de la technique pertinent est décrit dans US 4 939 101 A; CN 110 098 140 A; US 4 818 323 A et US 6 010 591 A.

### OBJET DE L'INVENTION

La présente invention vise à remédier à tout ou partie des inconvénients précités. Elle concerne un procédé d'assemblage de deux substrats semi-conducteurs par adhésion moléculaire, autorisant une bonne conduction électrique et thermique de l'interface d'assemblage, et qui réduit le nombre de défauts de collage, voire élimine totalement leur apparition.

### BREVE DESCRIPTION DE L'INVENTION

En vue de la réalisation de ce but, l'objet de l'invention propose un procédé d'assemblage de deux substrats semi-conducteurs par adhésion moléculaire comprenant :
- une étape a) de mise en contact intime d'un premier et d'un deuxième substrat pour former un ensemble présentant une interface de collage ;
- une étape b) de recuit de réaction de l'interface de collage à une première température, supérieure à une première température prédéterminée, cette étape b) générant des bulles à l'interface de collage ;
le procédé étant caractérisé en ce qu'il comprend :
- une étape c) de décollement au moins partiel des deux substrats au niveau de l'interface de collage afin d'éliminer les bulles;
- une étape d) de remise en contact intime du premier et du deuxième substrat au niveau de l'interface de collage pour reformer l'ensemble.

Selon d'autres caractéristiques avantageuses et non limitatives de l'invention, prises seules ou selon toute combinaison techniquement réalisable :
- l'étape c) de décollement est effectuée dans une atmosphère contrôlée ;
- l'atmosphère contrôlée de l'étape c) de décollement est une atmosphère anhydre ou sous vide ;
- l'étape c) de décollement est réalisée en tout ou partie à une deuxième température supérieure ou égale à la température ambiante ;
- la deuxième température est inférieure à 700°C, préférentiellement inférieure à 200°C et encore plus préférentiellement inférieure à 100°C ;
- l'étape c) de décollement comprend la séparation mécanique des deux substrats par l'insertion d'une lame, entre les deux substrats, à l'interface de collage ;
- le procédé d'assemblage comprend, après l'étape d), une étape e) d'amincissement du premier substrat pour former une couche mince.
- le premier substrat comprend une face principale et un plan fragile enterré, la couche mince étant définie entre la face principale et le plan fragile enterré ;
- l'étape e) comprend une fracture le long du plan fragile enterré pour transférer la couche mince sur le deuxième substrat ;
- l'étape e) comprend un traitement thermique à une température supérieure ou égale à une deuxième température prédéterminée permettant une fracture spontanée le long du plan fragile enterré (1b) ; la première température de l'étape b) et la deuxième température de l'étape c) sont inférieures à la deuxième température prédéterminée.

### BREVE DESCRIPTION DES FIGURES

D'autres caractéristiques et avantages de l'invention ressortiront de la description détaillée de l'invention qui va suivre en référence aux figures annexées sur lesquels :
- La figure 1 présente une structure composite élaborée selon un procédé d'assemblage conforme à l'invention ;
- Les figures 2a à 2e présentent des étapes d'un procédé d'assemblage conforme à l'invention ;
- Les figures 3, 4a à 4e présentent des étapes alternatives ou optionnelles du procédé d'assemblage conforme à l'invention.

### DESCRIPTION DETAILLEE DE L'INVENTION

Comme énoncé précédemment, la présente invention porte sur un procédé d'assemblage, par adhésion moléculaire, d'un premier substrat 1 à un deuxième substrat 2, chaque substrat étant formé d'un matériau semi-conducteur.

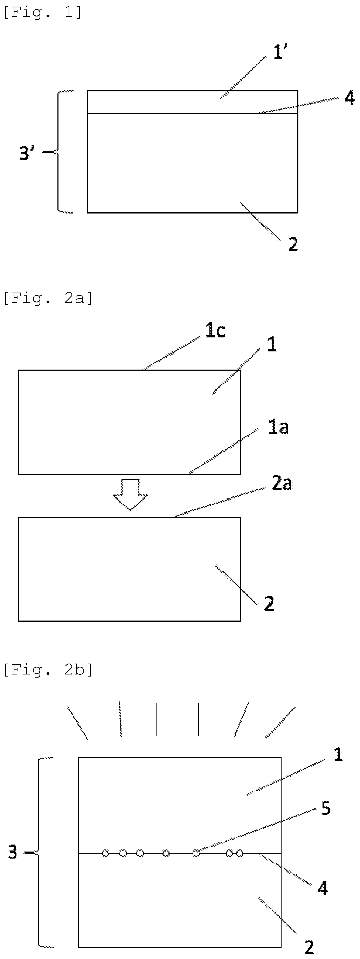

Plus particulièrement, l'invention cherche à former une structure composite 3' comprenant une couche mince 1' monocristalline disposée sur un substrat support 2 (figure 1). Le premier substrat 1 est destiné à former la couche mince 1' pour élaborer des composants, il est ainsi préférentiellement formé d'un matériau monocristallin de bonne qualité. Le deuxième substrat 2 est destiné à former le substrat support 2 de la structure composite 3', il peut ainsi être formé d'un matériau poly-cristallin ou monocristallin de moins bonne qualité.

Avantageusement, la couche mince 1' a une épaisseur inférieure à 1 micromètre, compatible avec une méthode de type Smart Cut. Avant d'être assemblés, le premier substrat 1 et le deuxième substrat 2 possèdent une épaisseur de l'ordre de quelques centaines de micromètres.

Ces deux substrats 1,2 peuvent être formés de matériaux semi-conducteurs différents ou identiques choisis parmi le carbure de silicium (SiC), le phosphure d'indium (InP). Plus généralement, ces matériaux peuvent être des composés binaires, ternaires ou quaternaire formés à partir des éléments de la colonne IV et des colonnes III et V du tableau périodique des éléments.

Les substrats 1,2 comprennent chacun une face dite « principale » 1a,2a qui correspond aux faces qui seront mises en contact intime pour réaliser l'assemblage.

Avant cette mise en contact intime, afin d'opérer un collage direct par adhésion moléculaire, les surfaces principales 1a,2a subissent avantageusement divers traitements. Ces traitements ont pour but de nettoyer les surfaces principales 1a,2a afin de retirer les contaminations (particulaire, organiques, ...), et potentiellement les activer, pour privilégier des terminaisons chimiques de surface favorables à la propagation de l'onde de collage et à la bonne tenue de l'interface de collage 4. Un polissage mécano-chimique des faces principales 1a,2a peut également être appliqué afin de rendre les surfaces principales 1a,2a les plus lisses possible. Il est également envisageable de former sur l'une des surfaces principales 1a,2a ou sur chacune d'elles, une couche intermédiaire électriquement conductrice qui pourra également être lissée par polissage mécano-chimique.

Les figures 2a à 2e illustrent des étapes du procédé d'assemblage selon l'invention.

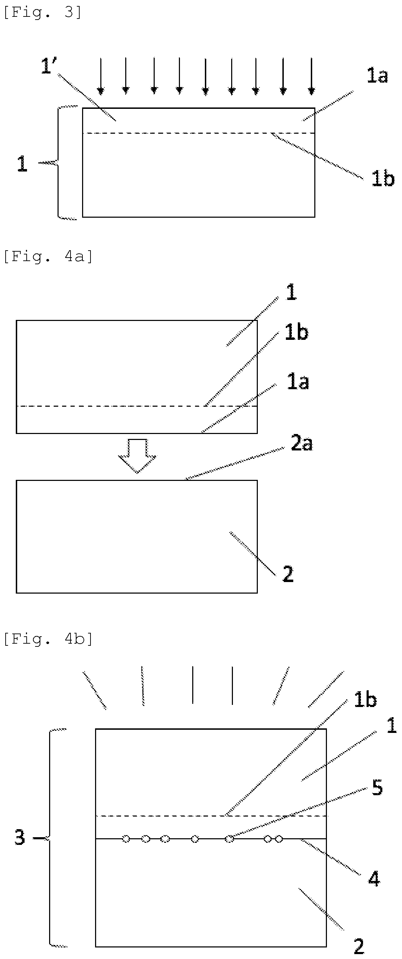

La première étape a) (figure 2a, 4a) de l'invention comprend la mise en contact intime de la face principale 1a du premier substrat 1 avec la face principale 2a du deuxième substrat 2 pour former un ensemble 3 présentant une interface de collage 4. Par contact « intime » on entend le fait de mettre directement en contact les surfaces principales 1a,2a, sans couche adhésive, pour les assembler par adhésion moléculaire le long d'une interface de collage 4.

La mise en contact intime des substrats 1,2 peut être faite sous atmosphère ambiante ou sous atmosphère contrôlée, par exemple sous gaz neutre et/ou sous vide. Il est envisageable d'effectuer cette mise en contact intime à température ambiante ou à plus haute température, par exemple entre 30°C et 500°C.

A l'issue de l'étape a), l'ensemble 3 est soumis, lors de l'étape b) (figure 2b, 4b) suivante, à un recuit de réaction de l'interface de collage, à une température (appelée première température par la suite) supérieure à une première température prédéterminée. Cette première température prédéterminée correspond à la température au-delà de laquelle les espèces piégées à l'interface de collage (par exemple, hydrogène, fluor, résidus de monocouches d'eau, dans le cas d'un collage hydrophobe) et/ou adsorbées préalablement à la mise en contact, au niveau des surfaces principales 1a,2a réagissent, en tout ou partie, pour former des bulles de gaz 5 à l'interface de collage 4. La durée de ce recuit est typiquement de 1h.

Dans le cas où les deux substrats 1,2 sont formés en SiC, cette première température prédéterminée est d'environ 200°C, la première température peut être choisie, par exemple, égale à 700°C.

Le gaz piégé dans ces bulles 5 peut par exemple être du dihydrogène, de la vapeur d'eau ou du dioxyde de carbone, ou autres gaz issus de la réaction thermiquement activée à l'interface de collage 4. Il a été constaté que ces bulles 5 pouvaient rester stables dans une large plage de températures, typiquement jusqu'à 1100°C, voire au-delà, dans le cas de substrats 1,2 en SiC. Cela est notamment gênant lorsqu'une étape ultérieure d'amincissement du procédé doit être opérée sans dépasser la plage précitée de stabilité des bulles 5 : les défauts de collage (correspondant aux bulles) sont susceptibles de dégrader l'intégrité et la qualité de la couche mince 1' issue de l'amincissement du premier substrat 1.

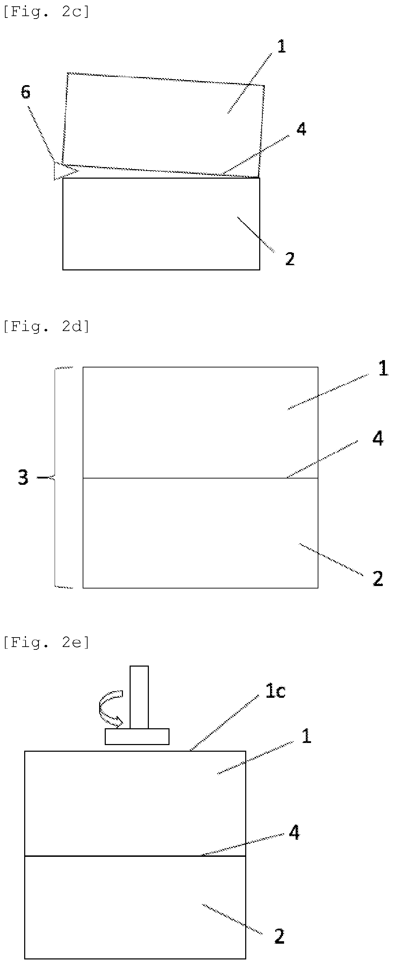

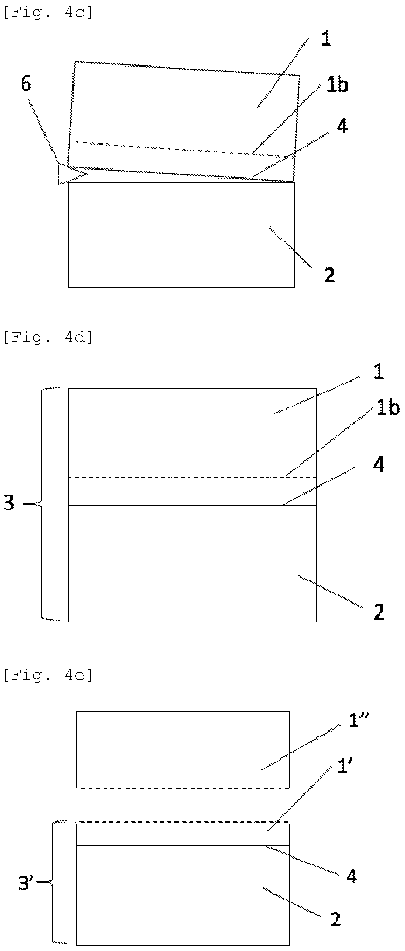

L'étape c) (figure 2c, 4c) suivante de l'invention comprend le décollement au moins partiel des deux substrats 1,2 au niveau de l'interface de collage 4. La séparation des deux substrats 1,2, par ouverture de l'interface de collage 4, permet d'éliminer les bulles 5 en libérant le gaz piégé dans celles-ci.

L'étape c) de décollement peut comprendre la séparation mécanique des deux substrats 1,2 par l'insertion d'une lame 6, entre les deux substrats 1,2, à l'interface de collage 4. Le matériau de la lame est choisi de manière à éviter toute contamination pour être compatible avec les applications microélectroniques. Il s'agit préférentiellement d'une lame en Téflon. Lors de son insertion à l'interface de collage 4, la lame 6 génère une onde de décollement se propageant le long de l'interface de collage 4 et provoquant la séparation des deux substrats 1,2. Il est nécessaire et suffisant que l'onde de décollement atteigne chacune des bulles 5 présentes à l'interface, de manière à libérer les gaz piégés, et à éliminer toutes les bulles 5 présentes. Le décollement n'est donc pas nécessairement effectué sur la totalité de l'interface de collage 4 ; les deux substrats 1,2 peuvent ainsi rester assemblés sur une portion de l'interface de collage 4.

Cette étape c) (figures 2c, 4c) de décollement est avantageusement effectuée dans une atmosphère contrôlée. Elle peut être réalisée dans une salle blanche, ou préférentiellement sous une atmosphère anhydre, tel que sous diazote sec ou sous vide afin de prévenir le dépôt de particules ou d'eau sur les faces principales 1a,2a des substrats 1,2 susceptible de générer des défauts de collage lors de l'étape suivante.

L'étape c) peut être effectuée, en tout ou partie, à une deuxième température supérieure ou égale à la température ambiante. Cette deuxième température est généralement inférieure à 700°C, préférentiellement inférieure à 200°C et plus préférentiellement inférieure à 100°C.

L'étape c) peut également comprendre une étape de gravure par faisceau d'ions des surfaces principales 1a,2a des deux substrats 1,2, afin de retirer une éventuelle couche d'oxyde. Il s'agit typiquement d'un bombardement d'ions d'Argon à une énergie de quelques dizaines à quelques centaines d'eV pendant quelques dizaines de secondes.

Les deux substrats 1,2 sont ensuite remis en contact intime au niveau de l'interface de collage 4, lors de l'étape d) (figure 2d, 4d) pour reformer l'ensemble 3 et assembler définitivement entre elles les surfaces principales 1a, 2a. Cette étape de remise en contact est préférentiellement réalisée dans une atmosphère contrôlée similaire en composition et en température à celle de l'étape c) pour éviter l'introduction de nouvelles impuretés qui pourraient générer de nouvelles bulles.

Après cette étape d), l'ensemble 3 pourra être soumis à des traitements thermiques sans générer de défaut de collage susceptible d'impacter négativement la qualité du substrat 1 ou de la couche mince 1' obtenue à l'issue de l'étape optionnelle e) d'amincissement à venir. Cette absence de défaut de collage dommageable peut s'expliquer par le fait qu'il n'y a plus ou très peu d'espèces susceptibles de réagir, avec la température, au niveau de l'interface de collage 4, après l'assemblage définitif. De plus, les précautions prises lors des étapes c) et d) pour éviter d'introduire de nouvelles impuretés contribuent également à l'absence de défaut de collage.

A l'issue de l'étape d), si l'application visée nécessite une couche mince 1' et que l'épaisseur initiale du premier substrat 1 ne convient pas, il est possible de réaliser une étape e) d'amincissement du premier substrat 1. Le fait de pouvoir soumettre l'ensemble 3 à des traitements thermiques sans générer de défaut de collage est tout particulièrement important si l'étape e) d'amincissement du premier substrat 1 comprend un traitement thermique. En effet, sans cela, il y aurait un risque d'impacter négativement la qualité de la couche mince 1' issue de l'étape e).

L'étape e) (figure 2e, 4e) d'amincissement du premier substrat 1 a pour but de former la couche mince 1' dans laquelle pourront ultérieurement être élaborés divers composants électroniques.

Selon un premier mode de réalisation (figure 2e), la couche mince 1' peut être formée par amincissement de la face arrière 1c du premier substrat 1 par rectification mécanique (« grinding » selon la terminologie anglo-saxonne), gravure chimique humide ou sèche et/ou polissage mécano-chimique, en alternance avec des séquences de nettoyage. Un (ou plusieurs) traitement(s) thermique(s) peut(vent) être appliqué(s) pour consolider l'interface de collage 4 et/ou améliorer la qualité cristalline et/ou de surface de la couche mince 1' sans générer l'apparition de nouvelles bulles à l'interface de collage 4.

Selon un deuxième mode de réalisation, la couche mince 1' peut être formée par un transfert de couche selon le procédé SmartCut^{™}. Dans ce cas, le procédé d'assemblage selon l'invention comprend, avant l'étape a) de mise en contact intime, une étape de formation d'un plan fragile enterré 1b dans le premier substrat 1 (figure 3), la couche mince 1' étant alors définie entre la face principale 1a et le plan fragile enterré 1b. De manière avantageuse, le plan fragile enterré 1b est créé par l'implantation ionique d'espèce légères jusqu'à une profondeur déterminée. Les espèces légères implantées sont préférentiellement de l'hydrogène, de l'hélium ou une co-implantation de ces deux espèces. Ces espèces légères vont former, autour de la profondeur déterminée, des microcavités distribuées dans une fine couche parallèle à la surface principale 1a du premier substrat 1. On appelle cette fine couche le plan fragile enterré 1b, par souci de simplification. L'énergie d'implantation des espèces légères est choisie de manière à atteindre la profondeur déterminée dans le premier substrat 1, ladite profondeur correspondant à une épaisseur visée de la couche mince 1'.

Les étapes a) à d) de ce deuxième mode de réalisation, illustrée par les figures 4a à 4d, sont conformes à la description générale précédente.

L'étape e) comprend la fracture le long du plan fragile enterré 1b pour séparer la couche mince 1' du reste 1" du premier substrat 1 et ainsi transférer la couche mince 1' sur le deuxième substrat 2 (figure 4e). Cette fracture peut être induite par application d'un traitement thermique à l'ensemble 3, à une température supérieure ou égale à une deuxième température prédéterminée. Cette deuxième température prédéterminée correspond à la température à partir de laquelle une fracture spontanée le long du plan fragile enterré 1b peut se produire. Elle est typiquement comprise entre 750° et 1000°C dans le cas d'un premier substrat 1 en SiC. Le traitement thermique de fracture pourra avoir une durée allant de quelques minutes à quelques heures. Au cours dudit traitement thermique, les microcavités présentes dans le plan fragile enterré 1b suivent une cinétique de croissance jusqu'à l'initiation spontanée d'une onde de fracture qui va se propager sur toute l'étendue du plan fragile enterré 1b et provoquer la séparation entre la couche mince 1' assemblée au deuxième substrat 2 et le reste 1" du premier substrat 1. Alternativement, la séparation peut être induite par application d'une contrainte localisée, ou par une combinaison de traitement thermique et de contrainte mécanique.

Toujours selon ce deuxième mode de réalisation, il est nécessaire que le matériau du premier substrat 1 et que les propriétés du plan fragile enterré 1b (liées aux conditions d'implantation des espèces légères) permettent d'obtenir une fracture à une deuxième température prédéterminée supérieure d'au moins 50 à 150°C à la première température de l'étape b), afin de ne pas provoquer prématurément la séparation de la couche mince 1' du reste 1" du premier substrat 1. Similairement, il est nécessaire que la première température de l'étape b) (figure 4b) et la deuxième température de l'étape c) (figure 4c) ne dépassent pas cette deuxième température prédéterminée.
Bien évidemment, on pourrait imaginer d'autres techniques que celles présentées ci-dessus pour former la couche mince 1' lors de l'étape e).

A l'issue des étapes a) à e) précitées, on obtientune structure composite 3' ne présentant pas de défaut de collage dommageable. La structure composite 3' obtenue possède ainsi une très bonne force d'adhésion entre la couche mince 1' et le substrat support 2.

Une telle structure composite 3' peut ainsi être utilisée pour y former une couche supplémentaire par épitaxie, par exemple d'épaisseur de 10 micromètres à 1700°C, dans laquelle seront former des dispositifs, sans crainte de détériorer la structure 3' .

La structure composite 3' peut également posséder une très bonne conduction électrique et thermique verticale entre la couche mince 1' et le substrat support 2. Cela est dû au choix des matériaux pour la couche mince 1' et le substrat support 2 et à l'absence de couche intermédiaire de collage pour les assembler.
Bien entendu l'invention n'est pas limitée au(x) mode(s) de mise en œuvre décrit (s) et on peut y apporter des variantes de réalisation sans sortir du cadre de l'invention tel que défini par les revendications.

## Revendications

1. Procédé d'assemblage de deux substrats semi-conducteurs par adhésion moléculaire comprenant :
- une étape a) de mise en contact intime d'un premier (1) et d'un deuxième substrat (2) pour former un ensemble (3) présentant une interface de collage (4) ;
- une étape b) de recuit de réaction de l'interface de collage à une première température, supérieure à une première température prédéterminée, cette étape b) générant des bulles à l'interface de collage ;
le procédé étant **caractérisé en ce qu'**il comprend :
- une étape c) de décollement au moins partiel des deux substrats (1,2) au niveau de l'interface de collage (4) afin d'éliminer les bulles;
- une étape d) de remise en contact intime du premier (1) et du deuxième substrat (2) au niveau de l'interface de collage (4) pour reformer l'ensemble (3).

2. Procédé d'assemblage selon la revendication précédente dans lequel l'étape c) de décollement est effectuée dans une atmosphère contrôlée.

3. Procédé d'assemblage selon la revendication précédente dans lequel l'atmosphère contrôlée de l'étape c) de décollement est une atmosphère anhydre ou sous vide.

4. Procédé d'assemblage selon l'une des revendications précédentes dans lequel l'étape c) de décollement est réalisée en tout ou partie à une deuxième température supérieure ou égale à la température ambiante.

5. Procédé d'assemblage selon la revendication précédente dans lequel la deuxième température est inférieure à 700°C, préférentiellement inférieure à 200°C et encore plus préférentiellement inférieure à 100°C.

6. Procédé d'assemblage selon l'une des revendications précédentes dans lequel l'étape c) de décollement comprend la séparation mécanique des deux substrats (1,2) par l'insertion d'une lame, entre les deux substrats (1,2), à l'interface de collage (4).

7. Procédé d'assemblage selon l'une des revendications précédentes comprenant, après l'étape d), une étape e) d'amincissement du premier substrat (1) pour former une couche mince (1').

8. Procédé d'assemblage selon la revendication précédente, dans lequel le premier substrat (1) comprend une face principale (1a) et un plan fragile enterré (1b), la couche mince (1') étant définie entre la face principale (1a) et le plan fragile enterré (1b).

9. Procédé d'assemblage selon la revendication précédente dans lequel l'étape e) comprend une fracture le long du plan fragile enterré (1b), pour transférer la couche mince (1') sur le deuxième substrat (2).

10. Procédé d'assemblage selon la revendication précédente dans lequel :
- l'étape e) comprend un traitement thermique à une température supérieure ou égale à une deuxième température prédéterminée permettant une fracture spontanée le long du plan fragile enterré (1b) ;
- la première température de l'étape b) et la deuxième température de l'étape c) sont inférieures à la deuxième température prédéterminée.

## Patentansprüche

1. Verfahren zum Verbinden von zwei Halbleitersubstraten durch molekulare Adhäsion, umfassend:
- einen Schritt a) eines Bringens in engen Kontakt eines ersten (1) und eines zweiten Substrats (2) zum Ausbilden einer Anordnung (3), die eine Klebeschnittstelle (4) aufweist;
- einen Schritt b) eines Reaktionsglühens der Klebeschnittstelle bei einer ersten Temperatur, die höher als eine erste vorbestimmte Temperatur ist, wobei dieser Schritt b) Blasen an der Klebeschnittstelle erzeugt;
wobei das Verfahren **dadurch gekennzeichnet ist, dass** es umfasst:
- einen Schritt c) eines mindestens teilweisen Ablösens der zwei Substrate (1,2) an der Klebeschnittstelle, (4) um die Blasen zu entfernen;
- einen Schritt d) eines Zurückbringens in engen Kontakt des ersten (1) und des zweiten Substrats (2) an der Klebeschnittstelle (4) zum Umformen der Anordnung (3).

2. Verbindungsverfahren nach dem vorstehenden Anspruch, wobei der Schritt c) des Ablösens in einer kontrollierten Atmosphäre durchgeführt wird.

3. Verbindungsverfahren nach dem vorstehenden Anspruch, wobei die kontrollierte Atmosphäre von dem Schritt c) des Ablösens eine wasserfreie oder Vakuumatmosphäre ist.

4. Verbindungsverfahren nach einem der vorstehenden Ansprüche, wobei der Schritt c) des Ablösens ganz oder teilweise bei einer zweiten Temperatur ausgeführt wird, die höher als oder gleich der Raumtemperatur ist.

5. Verbindungsverfahren nach dem vorstehenden Anspruch, wobei die zweite Temperatur weniger als 700 °C, vorzugsweise weniger als 200 °C und noch stärker bevorzugt weniger als 100 °C beträgt.

6. Verbindungsverfahren nach einem der vorstehenden Ansprüche, wobei der Schritt c) des Ablösens das mechanische Trennen der zwei Substrate (1,2) durch das Einführen einer Klinge zwischen den zwei Substraten (1,2) an der Klebeschnittstelle (4) umfasst.

7. Verbindungsverfahren nach einem der vorstehenden Ansprüche, umfassend nach dem Schritt d) einen Schritt e) eines Ausdünnens des ersten Substrats (1) zum Ausbilden einer dünnen Schicht (1').

8. Verbindungsverfahren nach dem vorstehenden Anspruch, wobei das erste Substrat (1) eine Hauptfläche (1a) und eine eingegrabene spröde Ebene (1b) umfasst, wobei die dünne Schicht (1') zwischen der Hauptfläche (1a) und der eingegrabenen spröden Ebene (1b) definiert ist.

9. Verbindungsverfahren nach dem vorstehenden Anspruch, wobei der Schritt e) einen Bruch entlang der eingegrabenen spröden Ebene (1b) zum Übertragen der dünnen Schicht (1') auf das zweite Substrat (2) umfasst.

10. Verbindungsverfahren nach dem vorstehenden Anspruch, wobei:
- Schritt e) eine Wärmebehandlung bei einer Temperatur umfasst, die höher als oder gleich einer zweiten vorbestimmten Temperatur ist, die einen Spontanbruch entlang der eingegrabenen spröden Ebene (1b) ermöglicht;
- die erste Temperatur von dem Schritt b) und die zweite Temperatur von dem Schritt c) geringer als die zweite vorbestimmte Temperatur sind.

## Claims

1. A method for joining two semiconductor substrates by molecular adhesion, comprising:
- a step a) of bringing a first substrate (1) and a second substrate (2) into intimate contact in order to form an assembly (3) having a bonding interface (4);
- a step b) of reaction-annealing the bonding interface at a first temperature that is greater than a first predetermined temperature, this step b) generating bubbles at the bonding interface;
the method being **characterized in that** it comprises:
- a step c) of at least partially debonding the two substrates (1,2) at the bonding interface (4) in order to eliminate the bubbles;
- a step d) of bringing the first substrate (1) and the second substrate (2) back into intimate contact at the bonding interface (4) in order to reform the assembly (3).

2. The joining method according to the preceding claim, wherein the debonding step c) is carried out in a controlled atmosphere.

3. The joining method according to the preceding claim, wherein the controlled atmosphere in the debonding step c) is an anhydrous atmosphere or vacuum.

4. The joining method according to any of the preceding claims, wherein the debonding step c) is carried out wholly or partly at a second temperature that is greater than or equal to the ambient temperature.

5. The joining method according to the preceding claim, wherein the second temperature is less than 700°C, preferably less than 200°C, and even more preferably less than 100°C.

6. The joining method according to any of the preceding claims, wherein the debonding step c) comprises mechanically separating the two substrates (1,2) by inserting a blade between the two substrates (1,2) at the bonding interface (4).

7. The joining method according to any of the preceding claims, comprising, after step d), a step e) of thinning the first substrate (1) to form a thin layer (1').

8. The joining method according to the preceding claim, wherein the first substrate (1) comprises a main face (1a) and a buried fragile plane (1b), the thin layer (1') being defined between the main face (1a) and the buried fragile plane (1b).

9. The joining method according to the preceding claim, wherein step e) comprises a fracture along the buried fragile plane (1b), in order to transfer the thin layer (1') onto the second substrate (2).

10. The joining method according to the preceding claim, wherein:
- step e) comprises a heat treatment at a temperature greater than or equal to a second predetermined temperature, which causes a spontaneous fracture along the buried fragile plane (1b);
- the first temperature of step b) and the second temperature of step c) are lower than the second predetermined temperature.
